# EUROPEAN PATENT APPLICATION

(11) **EP 1 881 506 A1**
(43) Date of publication of application: **23.01.2008**
(21) Application number: 06714232.3
(22) Date of filing: 15.02.2006
(51) Int. Cl.: H01B 1/22, H01B 1/00, H05K 3/46

(54) **CONDUCTOR PASTE AND ELECTRONIC COMPONENT**

(30) Priority: 28.03.2005 JP 2005090624
(71) Applicant: NGK INSULATORS, LTD., Nagoya-shi, Aichi 467-8530 (JP); Soshin Electric Co. Ltd., Saku-shi, Nagano 385-0021 (JP)
(72) Inventor: OOBUCHI, Takeshi, u, Nagoya-shi, Aichi, 4678530 (JP); IDE, Yoshinori, 1, Sarukubo, Saku-shi, Nagano, 3850011 (JP)
(74) Representative: Paget, Hugh Charles Edward
(86) International application number: PCT/JP2006/303092
(87) International publication number: WO 2006/103847

(57) **Abstract**

A conductive paste comprising silver powder as a major component and metal oxide powder of which primary particles have a hollow structure is used. The metal oxide is preferably silica. In an electronic part comprising a ceramic body and an internal electrode formed inside the ceramic body, preferably, the internal electrode is formed from the conductive paste. A surface layer electrode can be also formed from the conductive paste.

## Description

### FIELD OF THE INVENTION

The present invention relates to a conductive paste and electronic parts.

### BACKGROUND OF THE INVENTION

In high-frequency circuit wireless equipment such as a cellular phone, a dielectric laminated filter has been used as a high-frequency circuit filter, for example, as a top filter, a transmitting inter-stage filter, a local filter, or a receiving inter-stage filter.

For manufacturing the dielectric laminated filter, a plurality of ceramic powder compacts constituting a dielectric body is made, and a predetermined electrode pattern is formed on each compact by applying a predetermined conductive paste to each compact. Then, the resulting compacts are laminated to constitute a laminated body, and the laminated body is sintered, whereby the conductor paste layer and each compact are simultaneously sintered and compacted.

In this case, a conductor of low-melting point metal such as a silver-based conductor, a copper-based conductor or a nickel-based conductor is generally used as an electrode, and the melting point of such a conductor is, for example, 1100°C or lower and may be reduced to about 930°C in some cases. Therefore, the dielectric body must be sintered at a sintering temperature lower than the melting point of the low-melting point metal forming the electrode.

The conductive paste for manufacturing the dielectric laminated filter is described, for example, in Japanese Patent Publication No. 2002-232204A. This conductive paste is prepared by coating the surface of silver powders with alumina and dispersing the coated particles into a solvent. This conductive paste is screen-printed on a dielectric layer, whereby an electrode pattern of the conductive paste is formed.

In Japanese Patent No. 3276961B, further, a conductive paste is prepared by adding fine particles of oxide bismuth-silica-alumina-based non-lead glass to conductive particles, and dispersing the resulting mixture in an organic solvent. This conductive paste is applied onto a rigid substrate, whereby a thick film conductor pattern is formed.

### DISCLOSURE OF THE INVENTION

As a result of attempts to form an internal electrode for dielectric laminated filter using various kinds of conductive pastes of the related arts, the present inventors found that the following problem can be still caused. Namely, since simultaneous sintering of dielectric porcelain (ceramics) and the internal electrode is performed in the dielectric laminated filter, an internal stress is caused due to difference in sintering contraction behavior or in physical properties between the both.

An inner layer electrode means a layered electrode formed inside the ceramics, including a resonator electrode for resonating a specific wavelength, input and output electrodes for inputting and outputting external high-frequency signal, a coupling electrode for inductively coupling resonators, and an inner layer earth electrode for adjusting electric length of a resonator electrode.

It is desired to form a number of porcelain layers and resonator electrodes within a fixed dimension by minimizing the thickness of a porcelain layer placed between resonator electrodes while reducing the insertion loss of the dielectric laminated filter. However, as the thickness of the porcelain layer between resonator electrodes is minimized to increase the number of layers of resonator electrodes, the internal stress is increased although Q value of resonators is improved. Consequently, cracking of the porcelain around the electrode including the resonator electrodes or delamination at an interface between resonator electrode and porcelain is easily caused.

An object of the present invention is thus to reduce, in formation of a conductor pattern by applying a conductive paste in contact with porcelain followed by sintering, the internal stress between the conductor pattern and the porcelain to suppress the cracking of the porcelain.

The present invention provides a conductive paste comprising silver powder as a major component and metal oxide powder whose primary particles have a hollow structure.

The present invention further provides an electronic part comprising a ceramic body and an internal electrode formed inside the ceramic body, the internal electrode being made from the above-mentioned conductive paste. The present invention also provides an electronic part comprising a ceramic body and a surface layer electrode formed on the surface side of the ceramic body, the surface layer electrode being made from the above-mentioned conductive paste.

According to a dielectric laminated filter, for example, distortion is caused due to the difference in sintering contraction behavior between inner layer electrode and porcelain in the temperature rising process for sintering. As the number of layers of resonator electrodes forming a part of the inner layer electrode is increased, the above-mentioned distortion may be increased, causing cracking in the porcelain between the resonator electrodes.

In order to suppress such cracking, the present inventors paid attention to the sintering contraction behaviors of, for example, the resonator electrode and the porcelain. Consequently, it was found that the distortion between electrode and porcelain can be reduced and cracking in the porcelain between electrodes can be suppressed by using a conductive paste comprising silver powder as a major component and metal oxide powder of hollow structure. Further, in the case of a surface layer electrode (terminal electrode), the distortion between surface layer electrode and porcelain can be reduced to reduce cracking in the porcelain by using a conductive paste containing metal oxide powder of hollow structure.

### BRIEF DESCRIPTION OF THE DRAWINGS

Fig. 1 is a perspective view schematically showing a dielectric laminated filter 1 to which the present invention is applicable.
Fig. 2 is a cross-sectional view schematically showing one example of the dielectric laminated filter 1.
Figs. 3 are a perspective view and a partially enlarged view showing a preferred construction example of the dielectric laminated filter.
Fig. 4 is a projection view of an internal electrode in the filter of Fig. 3.
Fig. 5 is a microscopic image of hollow silica powder.
Fig. 6 is a microscopic image of solid silica powder.
Fig. 7 is a microscopic image of solid silica powder.
Fig. 8 is a graph showing the sintering contraction behavior of a paste when a trace amount of hollow silica powder is added to silver paste.

### BEST MODES FOR CARRYING OUT THE INVENTION

According to the present invention, the metal oxide powder includes primary particles of hollow structure or composite particles in which the primary particles are aggregated. The hollow structure means hollow powder in the powder technology field, such that voids can be observed in a section of the particle with field emission scanning electron microscope (FE-SEM) shown below.

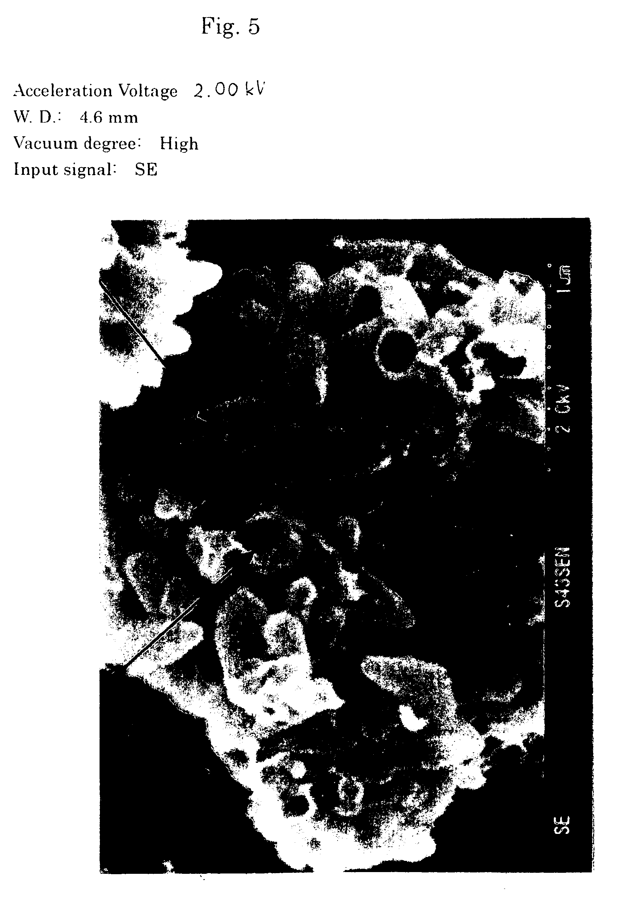

For example, Fig. 5 shows silica powder including primary particles having a hollow structure, which was used in the present invention. The arrowed portion corresponds to a primary particle having a hollow structure, which has a spindle shape. Individual particles observed in this image are defined as primary particles. The composite particle formed by aggregating a plurality of the primary particles is defined as a secondary particle.

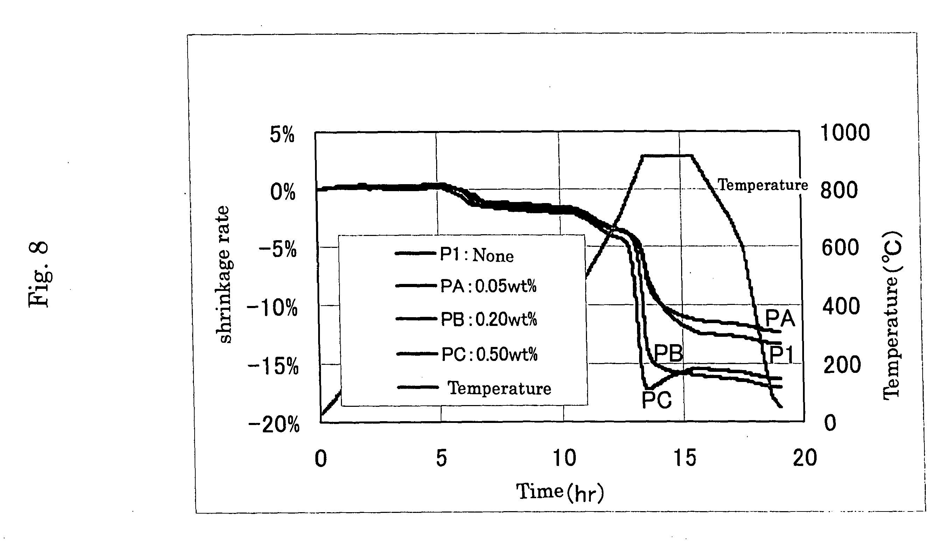

It was found that the sintering contraction behavior of silver paste can be controlled by adding silica powder of the primary particles having a hollow structure to the silver paste. The graph of Fig. 8 shows the sintering contraction behavior of a silver paste dried body when silica particles of primary particles of hollow structure is added to the silver paste. Hollow silica powder is not included in PI and added in PA, PB and PC at amounts of 0.05 wt%, 0.20 wt%, and 0.50 wt%, respectively. As is apparent from the graph, the sintering contraction behavior is significantly changed depending on trace addition of the hollow silica powder. Consequently, the sintering contraction behavior of the silver paste dried body can be controlled by adding a trace amount of hollow silica.

When the primary particles have a hollow structure, the cracking or the delamination can be further suppressed by the effect of the hollow structure as a cushion for internal stress.

### (Observation Condition of Hollow Structure of Primary Particle)

Apparatus: S-4300SE-N, by Hitachi Ltd.

Condition: Acceleration voltage 2 kV, Vacuum 10⁻⁴ Pa or less, Secondary electron beam image

Production condition of observation sample: no vapor deposition

A typical spindle-shaped primary particle of hollow structure has a long axis diameter of 0.05 to 3 µm, a short axis diameter of 0.05 to 1.5 µm, and a hollow wall thickness of 0.01 to 0.1 µm.

Since deviation of shape is involved in the manufacturing, spherical particles with changed long axis diameter and short axis diameter may be included. Further, some particles may show a small spherical shape of 0.1 µm or less due to deviation of size.

In the present invention, as the metal oxide powder, silica is particularly preferred although the following ones can be exemplified. Preferred examples of the metal oxide powder include SiO₂, Al₂O₃, TiO₂, ZrO2, Y₂O₃ or composite oxides thereof. Other component elements or other component oxides may be included in an amount of 10 wt% or less with respect to those metal oxides.

The type of the metal oxide powder is not limited. The primary particles of the metal oxide may exist as composite particles in which a plurality of the primary particles is aggregated.

The composite particles preferably have the following particle size distribution. When the size is smaller than the following particle size distribution, deteriorated dispersibility to silver paste may make satisfactory electrode formation difficult. When it is larger than the following particle size distribution, irregularities by the composite particles are formed on the electrode surface as flaws of the electrode, causing deterioration of reliability.

The satisfactory particle size distribution range of the composite particles is as follows.
10%-average particle size: 0.5 to 3.5 µm
50%-average particle size: 1.5 to 5.0 µm
90%-average particle size: 3.6 to 6.0 µm

### (Particle size measurement condition)

Apparatus: Laser diffraction/scattering particle size distribution measuring system (LA-920 by HORIBA)
Dispersing liquid: Aqueous solution of hexametaphosphoric acid
Ultrasonic distribution time: 5 minutes
Relative refractive index: 140A000I

In a preferred embodiment of the present invention, the metal oxide powder is included in an amount of 0.02 to 2.0 parts by weight to 100 parts by weight of silver powder. A suppressing effect of cracking can be obtained by including 0.01 parts by weight or more of the metal oxide powder, and the cracking ratio can be suppressed to less than 1% by setting the addition amount of the metal oxide powder to 0.02 parts by weight or more and 2.0 parts by weight or less. The cracking ratio is 0% when the addition amount of the metal oxide powder ranges from 0.04 parts by weight or more to 1.0 part by weight or less.

On the viewpoint of the present invention, the addition amount of the metal oxide powder is preferably 0.02 parts by weight or more and 2.0 parts by weight or less and, further preferably, 0.04 parts by weight or more and 1.0 part by weight or less.

The metal oxide powder or silica powder including the primary particles of hollow structure or the composite particles preferably has a specific surface area of 50m²/g or more and 850m²/g or less on the viewpoint of the present invention.

As the metal oxide to be added, both crystalline and amorphous ones can be used regardless of the crystallinity.

The conductive paste of the present invention, which is principally composed of silver powder, can contain other metals, preferably, noble metals. In a preferred embodiment of the present invention, the conductive paste contains one or more element(s) selected from the group consisting of palladium and platinum in a ratio of total of 15.0 parts by weight or less with respect to 100 parts by weight of the silver powder. The silver paste of the present invention may further contain oxides other than those described in the present application, with the content thereof being preferably 2.0 parts by weight or less with respect to 100 parts by weight of the silver powder.

When the addition amount of the metal oxide having a hollow structure is within a range of 0.02 to 2.0 parts by weight, the insertion loss of the dielectric laminated filter is not deteriorated.

The kind of the ceramic body is not particularly limited. The ceramic body preferably consists of porcelain for electronic parts. As the composition system of such porcelain, for example, the followings can be given.
(1) BaO-TiO₂-Re₂O₃-Bi₂O₃-based composition (Re: rare earth component) added with a slight amount of glass forming component or glass powder
(2) BaO-TiO₂-ZnO-based composition added with a slight amount of glass forming component or glass powder
(3) BaO-Al₂O₃-SiO₂-based composition containing zinc oxide, bismuth oxide or copper oxide, as occasion demands, and added with a slight amount of glass forming component or glass powder
(4) MgO-CaO-TiO2-ZnO-Al₂O₃-SiO₂-B₂O₃
(5) BaO-TiO2-based composition free from or added with a slight amount of glass forming component or glass powder

The electronic parts targeted by the present invention include, for example, a dielectric laminated filter, a multilayer wiring board, a dielectric antenna, a dielectric coupler, and a dielectric composite module without particular limitation.

The conductive paste of the present invention may be used for forming an internal electrode of such an electric part or for forming a surface layer electrode of such an electronic part, for example, a terminal electrode. The internal stress which can be caused between the surface layer electrode and the porcelain or between the terminal electrode and the porcelain can be reduced by controlling the sintering contraction behavior of the surface layer electrode or the terminal electrode.

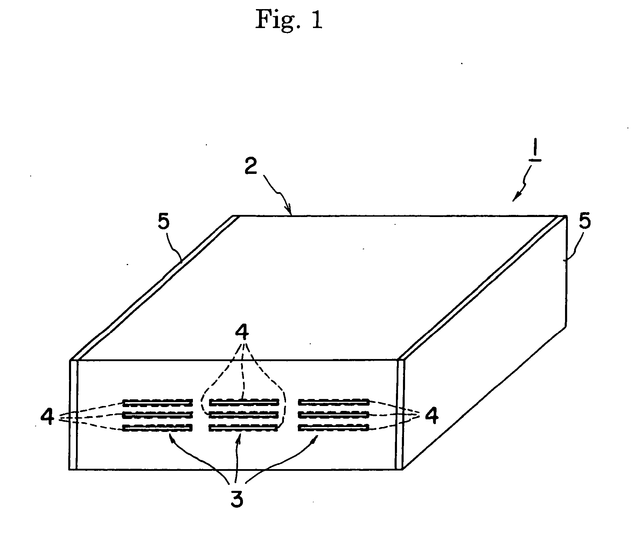

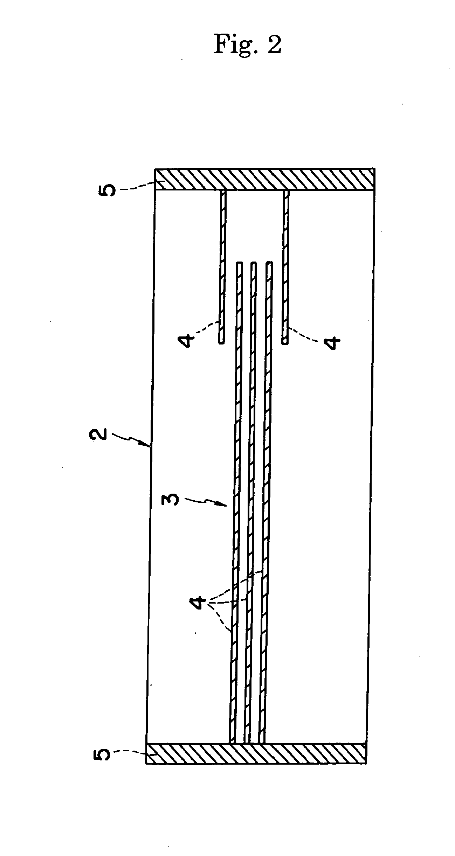

Fig. 1 is a perspective view schematically showing a dielectric laminated filter 1 according to an embodiment of the present invention, and Fig. 2 is a cross-sectional view of the filter 1. As shown in Figs. 1 and 2, the dielectric laminated filter comprises, for example, three sets of resonators 3 within a dielectric substrate 2 constituted by laminating a plurality of dielectric layers. Each set of resonator 3 is constituted by laminating, for example, three inner layer electrodes (resonator electrodes) 4 in the laminating direction, with dielectric layers interposed each between the resonance electrodes 4 in the laminating direction.

When each of the resonance electrodes 4 is a 1/4-wavelength resonance electrode, the following structure is applied. That is, surface layer electrodes 5 are formed on the side face of the dielectric substrate 2 to which the resonance electrodes 4 are exposed, and one-side ends of the resonance electrodes 4 are short-circuited with the surface layer electrodes 5. In this case, the porcelain thickness between resonator electrodes can be set to 8 to 160 µm, and the resonator thickness to 5 to 30 µm.

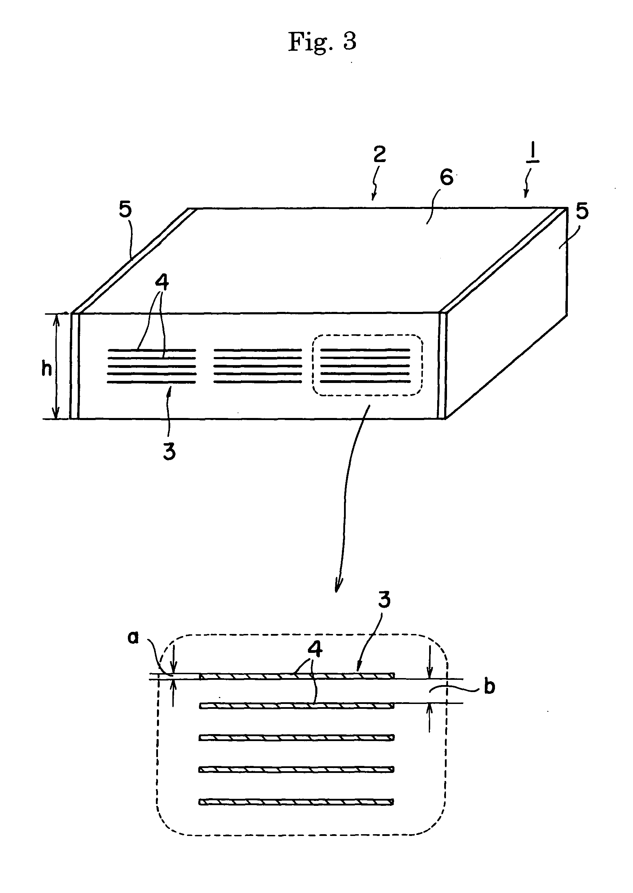

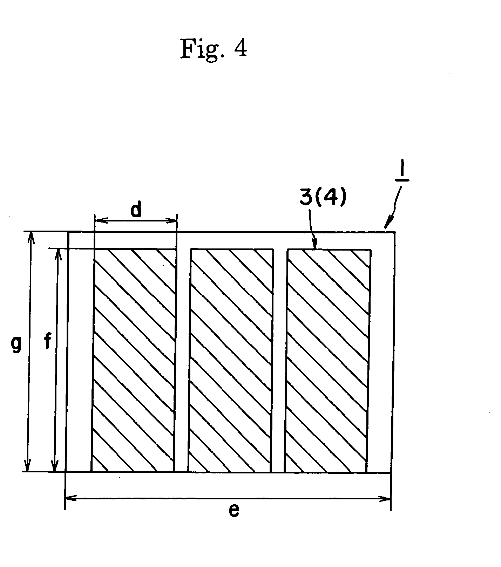

As a dimensional example, the chip shown in Fig. 4 has e of 2.5 mm and g of 2.0 mm, and the resonator thickness is 10 µm (a in Fig. 3). The porcelain thickness between resonators is 33 µm (b in Fig. 3), and the number of layers of resonators is 5. Five-laminated resonators are arranged in three columns in the planar direction. Each resonator has a width of 0.5 mm (d in Fig. 4) and a length of 1.8 mm (f in Fig. 4). In the case of a laminated capacitor, the porcelain thickness may be 10 µm or less.

In production of the low-temperature sintered porcelain according to the present invention, mixed powder is prepared by mixing starting materials of the metal components at a predetermined ratio, the mixed powder is calcined at 900 to 1300°C, and the calcined body is pulverized, whereby ceramic powder is obtained. A green sheet is made preferably using the ceramic powder and glass powder composed of, for example, SiO₂, B₂O₃ and ZnO. The green sheet is sintered at 850 to 930°C. As the starting materials of the metal components, the oxide, nitrate, carbide, sulfate and the like of each metal can be used.

### EXAMPLES

### [Experiment A]

### (Preparation of ceramic powder)

Each powder of barium carbide, titanium oxide, zinc oxide, aluminum oxide, and manganese oxide is weighted so as to have a predetermined composition, and wet-mixed. The composition of barium carbide, titanium oxide, zinc oxide, aluminum oxide and manganese oxide is 12:53:33:1:1 mol% by mole ratio. This powder is calcined at 1100 to 1200°C, whereby calcined powder is obtained. For examination of crystal phase and crystallinity of the calcined body, powdery X-ray diffraction measurement is performed thereto. Thereafter, the calcined powder is pulverized into a predetermined particle size by a ball mill, and the resulting powder is dried, whereby ceramic powder is obtained.

### (Preparation of glass powder)

Each powder of zinc oxide, boron oxide and silicon oxide is weighted and dry-mixed, the mixed powder is melted in a platinum crucible, and the melted material is rapidly cooled by being dropped into water, whereby massy glass is obtained. This glass is wet-pulverized, whereby low-melting point glass powder is obtained. The weight ratio of zinc oxide, boron oxide and silicon oxide is 62:29:9 wt%.

### (Tape molding)

A green sheet molding slurry is prepared by wet-mixing the resulting ceramic powder and glass powder with an organic binder, a plasticizer, a dispersion agent and an organic solvent by use of an alumina pot and an alumina ball. This slurry is molded into each green sheet 0.01 to 0.2 mm thick by a doctor blade device.

### (Formation of conductor)

A conductive paste is screen-printed on each green sheet to form a capacitor electrode pattern or resonator electrode pattern. A predetermined number of resulting green sheets are laminated to form a laminated body, which is then cut into a shape of 3.1mmx2.5mmx1.6mm by a dicer, and sintered at 920°C for 2 hours, whereby a sintered body is obtained.

### (Content of conductive paste)

As the metal oxide powder for the conductive paste, silica is used as shown in Table 1. In Tables 1 to 6, "Ex. " represents examples within the present invention, and "Com. Ex. " represents comparative examples out of the present invention.

The addition amount of the metal oxide powder (to 100 parts by weight of silver powder) is varied as shown in Table 1.

The sintered body of each example is evaluated for cracking. The confirmation of cracking is performed by determining a crack portion from image data of ultrasonic echo reflection by an ultrasonic flaw detector ("MI-SCOPE" by Hitachi Construction Machinery Co., Ltd.). Other characteristics are measured as follows.

### (Specific surface area of metal oxide powder)

Apparatus: Flow Sorb II 2300 by Shimadzu Corporation
Sample amount: 0.10 to 1.0 g
Pretreatment of powder: 200°Cx30 min

Measuring method: The metal oxide powder is put in a measuring glass container followed by 200°CX30min-degassing. After the degassed measuring glass container containing the metal oxide powder is set in the apparatus, specific surface area measurement is performed.

### (Conductor resistance)

The conductive paste is printed on an alumina substrate followed by sintering to form a strip line on the alumina substrate. Measurement of conductor resistance is performed thereto using four-terminal method. The strip line used in this experiment is 0.45 mm in width, 20 mm in length, and 10 µm in thickness.

### (Sintering contraction behavior)

The conductive paste is passed through a 250 µm-mesh sieve after 120°C×4hr-drying, uniaxially die-pressed at a pressure of 2MPa, and then cut into a predetermined shape by a dicer. The cut piece is degreased and sintered, and measurement of sintering contraction behavior is performed thereto using a thermal dilatometer.

Thermal dilatometer used in this experiment: Thermo Plus TMA 8310 by Rigaku Corporation

| Table 1 Items | Metal Oxide | Metal Oxide Added amount (Weight Parts) | Structure | Particle size distribution (µm) particle size distribution of composite Surface particles in hollow particles; particle size distribution of primary Metal particles in solid particles | | | Specific Area of Oxide Powder (m²/g) | Conductor Resistance mΩ/ 10µm □ | Occurrence of cracks |
|---|---|---|---|---|---|---|---|---|---|
| | | | | 10% Average Particle size | 50% Average Particle size | 90% Average Particle size | | | |
| Com. Ex. A1 | None | - | - | - | - | - | - | 2.15 | 854/1000 |
| Ex. A1 | SiO₂ | 0.01 | Hollow | 2.6 | 3.4 | 4.3 | 1.0×10² | 2.15 | 85/1000 |
| Ex. A2 | SiO₂ | 0.02 | Hollow | 2.6 | 3.4 | 4.3 | 1.0×10² | 2.15 | 2/1000 |
| Ex. A3 | SiO₂ | 0.04 | Hollow | 2.6 | 3.4 | 4.3 | 1.0×10² | 2.15 | 0/1000 |
| Ex. A4 | SiO₂ | 0.20 | Hollow | 2.6 | 3.4 | 4.3 | 1.0×10² | 2.17 | 0/1000 |
| Ex. A5 | SiO₂ | 0.50 | Hollow | 2.6 | 3.4 | 4.3 | 1.0×10² | 2.17 | 0/1000 |
| Ex. A6 | SiO₂ | 1.00 | Hollow | 2.6 | 3.4 | 4.3 | 1.0×10² | 2.21 | 0/1000 |
| Ex. A7 | SiO₂ | 2.00 | Hollow | 2.6 | 3.4 | 4.3 | 1.0×10² | 2.38 | 4/1000 |
| Ex. A8 | SiO₂ | 5.00 | Hollow | 2.6 | 3.4 | 4.3 | 1.0×10² | 2.75 | 49/1000 |

The paste in Comparative Example A1 which is free from metal oxide had a high cracking rate of 85.4%. In Examples A1 to A8 with addition of silica powder having a hollow structure, the cracking rate was lowered. Particularly, the cracking rate was 0% in Examples A3 to A6.

### (Experiment B)

Each sample of Comparative Examples B1 to B9 shown in Table 2 was produced in the same manner as in Example A except using amorphous solid silica particle as the metal oxide powder in Experiment B. The result is shown in Table 2.

| Table 2 Items | Metal Oxide | Metal Oxide Added amount (Weight Parts) | Structure | Particle size distribution (µm) particle size distribution of composite particles in hollow particles; particle size distribution of primary particles in solid particles | | | Specific Surface Area of Metal Oxide Powder (m²/g) | Conductor Resistance mΩ/ 10µm □ | Occurrence of cracks |
|---|---|---|---|---|---|---|---|---|---|
| | | | | 10% Average Particle size | 50% Average Particle size | 90% Average Particle size | | | |
| Com. Ex.B1 | SiO₂ | 0.01 | Solid | 2.5 | 3.7 | 4.1 | 0.4 | 2.15 | 814/1000 |
| Com. Ex.B2 | SiO₂ | 0.02 | Solid | 2.5 | 3.7 | 4.1 | 0.4 | 2.15 | 809/1000 |
| Com. Ex.B3 | SiO₂ | 0.04 | Solid | 2.5 | 3.7 | 4.1 | 0.4 | 2.15 | 803/1000 |
| Com. Ex.B4 | SiO₂ | 0.20 | Solid | 2.5 | 3.7 | 4.1 | 0.4 | 2.17 | 782/1000 |
| Com. Ex.B5 | SiO₂ | 0.50 | Solid | 2.5 | 3.7 | 4.1 | 0.4 | 2.19 | 765/1000 |
| Com. Ex.B6 | SiO₂ | 1.00 | Solid | 2.5 | 3.7 | 4.1 | 0.4 | 2.24 | 741/1000 |
| Com. Ex.B7 | SiO₂ | 2.00 | Solid | 2.5 | 3.7 | 4.1 | 0.4 | 2.60 | 717/1000 |
| Com. Ex. B8 | SiO₂ | 5.00 | Solid | 2.5 | 3.7 | 4.1 | 0.4 | 3.10 | 684/1000 |

As shown in Table 2, even if 0.01 to 5.0 parts by weight of the solid silica particle is added, the cracking rate could not be reduced to less than 68.4%.

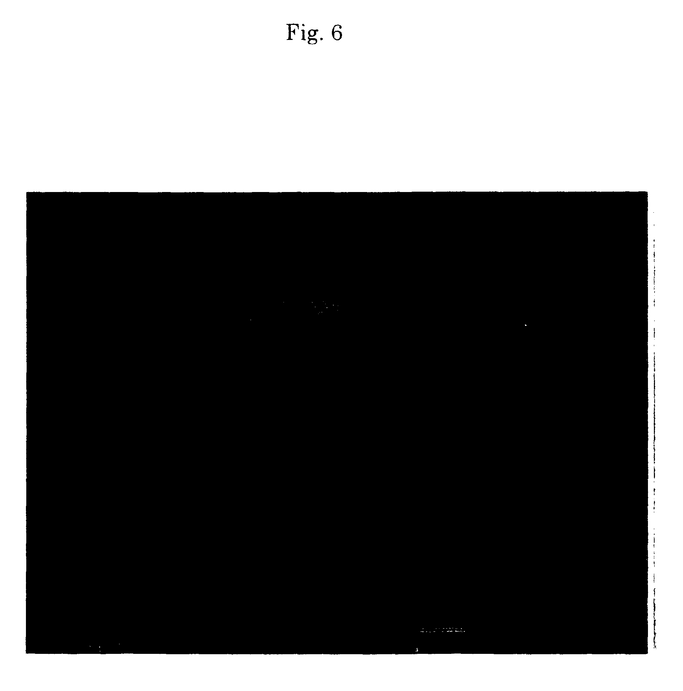

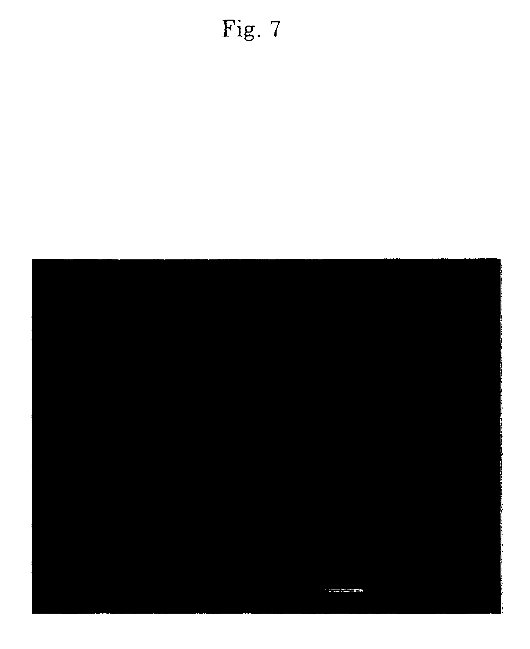

A photographic image of hollow silica, which is used in Examples A1 to A8, is shown in Fig. 5. Photographic images of solid silica particles used in Comparative Example B1 and the like are shown in Figs. 6 and 7.

### (Experiment D)

Each sample shown in Table 3 is produced in the same manner as in Experiment A, and observed for cracking. As the metal oxide powder, amorphous hollow silica powder was used. The specific surface area was variously changed by varying the thickness of the hollow shell while fixing the addition amount of the silica powder to 0.04 parts by weight. Consequently, the cracking rate was 0% in Examples D1 to D5.

| Table 3 Items | Metal Oxide | Metal Oxide Added amount (Weight Parts) | Structure | Particle size distribution (µm) particle size distribution of composite particles in hollow particles; particle size distribution of primary particles in solid particles | | | Specific Surface Area of Metal Oxide Powder (m²/g) | Conductor Resistance mΩ/ 10µm □ | Occurrence of cracks |
|---|---|---|---|---|---|---|---|---|---|
| | | | | 10% Average Particle size | 50% Average Particle size | 90% Average Particle size | | | |
| Ex. D1 | SiO₂ | 0.04 | Hollow | 4.2 | 5.1 | 6.0 | 5.0×10 | 2.15 | 0/1000 |
| Ex. D2 | SiO₂ | 0.04 | Hollow | 2.5 | 3.7 | 4.1 | 1.0×10² | 2.15 | 0/1000 |
| Ex. D3 | SiO₂ | 0.04 | Hollow | 1.7 | 3.8 | 5.2 | 3.0×10² | 2.15 | 0/1000 |
| Ex. D4 | SiO ₂ | 0.04 | Hollow | 1.5 | 3.4 | 4.8 | 5.0×10² | 2.15 | 0/1000 |
| Ex. D5 | SiO₂ | 0.04 | Hollow | 2.3 | 4.2 | 5.9 | 8.5×10² | 2.22 | 0/1000 |

### (Example E)

Each sample shown in Table 4 was produced in the same manner as in Experiment A, and observed for cracking. As the metal oxide powder, α-alumina crystalline hollow or solid alumina powder was used. Consequently, in Comparative Example E1 having no addition of metal oxide, the cracking rate was as high as 85.4%. In Comparative Example E2 using solid alumina powder, no crack suppressing effect was observed. In Examples E1 to E8 with addition of alumina powder having a hollow structure, the cracking rate was suppressed. Particularly, the cracking rate was 0% in Examples E3 to E6.

| Table 4 Items | Metal Oxide | Metal Oxide Added amount (Weight Parts) | Structure | Particle size distribution (µm) particle size distribution of composite particles in hollow particles; particle size distribution of primary particles in solid particles | | | Specific Surface Area of Metal Oxide Powder (m²/g) | Conductor Resistance mΩ/ 10µm □ | Occurrence of cracks |
|---|---|---|---|---|---|---|---|---|---|
| | | | | 10% Average Particle size | 50% Average Particle size | 90% Average Particle size | | | |
| Com. Ex.E1 | None | | | | | | | 2.15 | 854/1000 |
| Com. Ex.E2 | Al₂O₃ | 0.04 | Solid | 2.5 | 3.7 | 4.2 | 0.3 | 2.15 | 842/1000 |
| Ex. E1 | Al₂O₃ | 0.01 | Hollow | 2.5 | 3.2 | 4.5 | 0.7×10² | 2.15 | 145/1000 |
| Ex. E2 | Al₂O₃ | 0.02 | Hollow | 2.5 | 3.2 | 4.5 | 0.7×10² | 2.15 | 5/1000 |
| Ex. E3 | Al₂O₃ | 0.04 | Hollow | 2.5 | 3.2 | 4.5 | 0.7×10² | 2.15 | 0/1000 |
| Ex. E4 | Al₂O₃ | 0.20 | Hollow | 2.5 | 3.2 | 4.5 | 0.7×10² | 2.17 | 0/1000 |
| Ex. E5 | Al₂O₃ | 0.50 | Hollow | 2.5 | 3.2 | 4.5 | 0.7×10² | 2.19 | 0/1000 |
| Ex. E6 | Al₂O₃ | 1.00 | Hollow | 2.5 | 3.2 | 4.5 | 0.7×10² | 2.23 | 0/1000 |
| Ex. E7 | Al₂O₃ | 2.00 | Hollow | 2.5 | 3.2 | 4.5 | 0.7×10² | 2.55 | 7/1000 |
| Ex. E8 | Al₂O₃ | 5.00 | Hollow | 2.5 | 3.2 | 4.5 | 0.7×10² | 2.98 | 67/1000 |

### (Experiment F)

Each sample shown in Table 5 was produced in the same manner as in Experiment A and observed for cracking. As the metal oxide powder, hollow or solid titania powder was used. Consequently, in Comparative Example F1 having no addition of metal oxide, the cracking rate was as high as 85.4%. In Comparative Example F2 using solid titania powder, no crack suppressing effect was observed. In Examples F1 to F8 with addition of titania powder having a hollow structure, the cracking rate was lowered. Particularly, the cracking rate was 0% in Examples F3 to F6.

| Table 5 Items | Metal Oxide | Metal Oxide Added amount (Weight Parts) | Structure | Particle size distribution (µm) particle size distribution of compositeArea particles in hollow particles; particle size distribution of primary particles in solid particles | | | Specific Surface of MetalOxide Powder (m²/g) | Conductor Resistance mΩ/ 10µm □ | Occurrence of cracks |
|---|---|---|---|---|---|---|---|---|---|
| | | | | 10% Average Particle size | 50% Average Particle size | 90% Average Particle size | | | |
| Com. Ex.F1 | None | | | | | | | 2.15 | 854/1000 |
| Com. Ex.F2 | TiO₂ | 0.04 | Solid | 2.5 | 3.7 | 4.2 | 0.5 | 2.15 | 837/1000 |
| Ex. F1 | TiO₂ | 0.01 | Hollow | 2.5 | 3.2 | 4.5 | 0.9×10² | 2.15 | 136/1000 |
| Ex. F2 | TiO₂ | 0.02 | Hollow | 2.5 | 3.2 | 4.5 | 0.9×10² | 2.15 | 4/1000 |
| Ex. F3 | TiO₂ | 0.04 | Hollow | 2.5 | 3.2 | 4.5 | 0.9×10² | 2.16 | 0/1000 |
| Ex. F4 | TiO₂ | 0.20 | Hollow | 2.5 | 3.2 | 4.5 | 0.9×10² | 2.17 | 0/1000 |
| Ex. F5 | TiO₂ | 0.50 | Hollow | 2.5 | 3.2 | 4.5 | 0.9×10² | 2.20 | 0/1000 |
| Ex. F6 | TiO₂ | 1.00 | Hollow | 2.5 | 3.2 | 4.5 | 0.9×10² | 2.25 | 0/1000 |
| Ex. F7 | TiO₂ | 2.00 | Hollow | 2.5 | 3.2 | 4.5 | 0.9×10² | 2.36 | 5/1000 |
| Ex. F8 | TiO₂ | 5.00 | Hollow | 2.5 | 3.2 | 4.5 | 0.9×10² | 2.69 | 52/1000 |

### (Experiment G)

Ceramic green sheets were made in the same manner as in Experiment A. Conductive pastes of each composition shown in Table 6 were prepared in the same manner as in Experiment A. Each conductive paste was applied onto the green sheet and sintered in the same manner as in Experiment A, whereby a surface layer electrode (terminal electrode) was formed. The resulting conductor of each example was subjected to measurement of conductor resistance and cracking rate. The result is shown in Table 6.

| Table 6 Item | Metal Oxide | Metal Oxide Added amount (Weight Parts) | Structure | Particle size distribution (µm) particle size distribution of composite Area particles in hollow particles; particle size distribution of primary(m particles in solid particles | | | Specific Surface of Metal Oxide Powder ² /g) | Conductor Resistance mΩ/ 10µm □ | Occurrence of cracks |
|---|---|---|---|---|---|---|---|---|---|
| | | | | 10% Average Particle size | 50% Average Particle size | 90% Average Particle size | | | |
| Com. Ex. G1 None | | | | | | | | 2.15 | 854/1000 |
| Com. Ex.G2 | SiO₂ | 0.01 | Solid | 2.5 | 3.6 | 4.1 | 0.6 | 2.15 | 833/1000 |
| Ex. G1 | SiO₂ | 0.01 | Hollow | 2.6 | 3.4 | 4.3 | 1.0×10² | 2.15 | 127/1000 |
| Ex. G2 | SiO₂ | 0.02 | Hollow | 2.6 | 3.4 | 4.3 | 1.0×10² | 2.15 | 3/1000 |
| Ex. G3 | SiO₂ | 0.04 | Hollow | 2.6 | 3.4 | 4.3 | 1.0×10² | 2.15 | 0/1000 |
| Ex. G4 | SiO₂ | 0.20 | Hollow | 2.6 | 3.4 | 4.3 | 1.0×10² | 2.17 | 0/1000 |
| Ex. G5 | SiO₂ | 0.50 | Hollow | 2.6 | 3.4 | 4.3 | 1.0×10² | 2.21 | 0/1000 |
| Ex. G6 | SiO₂ | 1.00 | Hollow | 2.6 | 3.4 | 4.3 | 1.0×10² | 2.26 | 0/1000 |
| Ex. G7 | SiO₂ | 2.00 | Hollow | 2.6 | 3.4 | 4.3 | 1.0×10² | 2.38 | 5/1000 |
| Ex. G8 | SiO₂ | 5.00 | Hollow | 2.6 | 3.4 | 4.3 | 1.0×10² | 2.75 | 71/1000 |

As is apparent from this result, the number of cracks is large in Comparative Example G1 (free from hollow metal oxide particles) and Comparative Example G2 (solid silica-added). In contrast, the number of cracks was remarkably reduced in Examples G1 to G8 with addition of hollow silica particles. Particularly, the crack occurrence rate was 0% in Examples G3 to G6.

## Claims

1. A conductive paste comprising silver powder as a major component and metal oxide powder, said metal oxide powder comprising primary particles each having a hollow structure.

2. The conductive paste of claim 1, wherein the metal oxide powder comprises composite particles each comprising the primary particles aggregated.

3. The conductive paste of claim 1 or 2, wherein the primary particles have a spindle shape.

4. The conductive paste of any one of claims 1 to 3, wherein the metal oxide comprises silica.

5. The conductive paste of any one of claims 1 to 4, wherein the metal oxide powder is included in an amount of 0.02 to 2.0 weight parts with respect to 100 weight parts of the silver powder.

6. The conductive paste of any one of claims 1 to 5, further comprising one or more element(s) selected from the group consisting of palladium and platinum in a total amount of 15.0 weight parts or less with respect to 100 weight parts of the silver powder.

7. An electronic part comprising a ceramic body and an internal electrode formed inside the ceramic body, the internal electrode being formed using the conductive paste according to any one of claims 1 to 6.

8. An electronic part comprising a ceramic body and a surface layer electrode formed on a surface side of the ceramic body, the surface layer electrode being formed using the conductor paste according to any one of claims 1 to 6.
